# FASCICULE DE BREVET EUROPEEN

(11) **EP 1 143 620 B1**
(45) Date de publication et mention de la délivrance du brevet: **15.06.2011**
(21) Numéro de dépôt: 01400741.3
(22) Date de dépôt: 22.03.2001
(51) Int. Cl.: H03K 17/945

(54) **Détecteurs de proximité à apprentissage**
Lernfähiger Näherungsschalter
Proximity detector with learning capability

(30) Priorité: 31.03.2000 FR 0004245
(43) Date de publication de la demande: 10.10.2001
(73) Titulaire: Schneider Electric Industries SAS, 92500 Rueil-Malmaison (FR)
(72) Inventeur: Bernard, Jacques, Ing., 16340 l'Isle d'Espagnac (FR); Brault, Christophe, Ing., 16600 Touvres (FR)

(56) Documents cités:
- DE-A- 4 006 893
- DE-A- 4 331 555
- US-A- 5 818 129
- US-A- 5 895 441

## Description

La présente invention concerne un détecteur de proximité à apprentissage, par exemple du type inductif, délivrant un signal de sortie binaire de présence ou d'absence de cible et possédant un mode apprentissage pour réaliser l'auto-adaptation de la portée du détecteur par rapport à une cible et par rapport à un environnement.

La distance de détection propre à un tel appareil varie d'un détecteur à l'autre et pour un même détecteur, varie selon les conditions de montage et d'environnement, en particulier pour un détecteur inductif noyé dans une masse métallique. De plus, certaines applications nécessitent de pouvoir faire changer la sensibilité du détecteur selon son utilisation. Il est donc utile de pouvoir faire le réglage de la portée d'un détecteur de proximité sur son lieu d'utilisation.

Des détecteurs possédant, en plus d'un mode travail correspondant au mode de fonctionnement normal du détecteur, un mode apprentissage durant lequel est réalisé un réglage du détecteur, sont déjà connus (voir document EP 0740416). Il a aussi été proposé dans le brevet DE 4331555 de faire le réglage d'un détecteur de proximité par l'usage d'une unité de traitement à laquelle est connectée une mémoire non-volatile qui stocke, dans une phase apprentissage déclenchée par un signal d'étalonnage, un seuil de commutation élaboré à partir de la comparaison entre la valeur d'un compteur interne et la valeur du signal de détection du capteur. Par ailleurs, dans le document DE 4006893, l'élément de réglage du détecteur de proximité est constitué par une mémoire non-volatile pilotant au moyen d'un mot numérique plusieurs éléments de résistance, le sens de variation de cette mémoire ne pouvant être déterminé que par l'action d'un opérateur.

L'objectif de l'invention est de concevoir un détecteur de proximité capable de régler la portée de détection non seulement en fonction d'un type de cible à détecter mais aussi en fonction de l'environnement général du détecteur, ce qui lui permettra de s'adapter automatiquement et rapidement à de multiples utilisations différentes. On souhaite également éviter une consommation électrique trop importante du détecteur durant le mode travail afin notamment de ne pas dépasser le courant de fuite admissible, particulièrement pour les détecteurs de proximité à sortie de type deux fils. Cela implique que le détecteur doit être capable de fonctionner en mode travail sans surconsommation liée à l'unité de traitement et sans que le seuil de commutation issu du mode apprentissage ne soit sauvegardé dans une mémoire liée à l'unité de traitement. De même, durant le mode apprentissage, il est intéressant que l'opérateur puisse envoyer des instructions au détecteur mais aussi puisse recevoir des informations en retour lui indiquant l'état en cours du détecteur, tout ceci en conservant une solution simple et économique. Enfin, on souhaite utiliser des solutions qui permettent une miniaturisation poussée du détecteur.

Pour cela, l'invention décrit un détecteur de proximité comprenant un organe capteur apte à délivrer un signal analogique en fonction de la distance d'une cible, un étage de détection capable de délivrer un signal de détection résultat de la comparaison entre le signal analogique et un seuil de commutation, un étage de sortie chargé d'amplifier et de mettre en forme le signal de détection pour délivrer le signal de sortie du détecteur, et une unité de traitement recevant en entrée le signal de détection. Le détecteur est conçu pour fonctionner selon un mode apprentissage correspondant à un réglage de portée du détecteur et selon un mode travail correspondant au mode de fonctionnement normal du détecteur. Il se caractérise par le fait que le détecteur comprend une résistance variable numérique à mémorisation, pilotée par l'unité de traitement et reliée à l'étage de détection de telle façon qu'une variation de la valeur de cette résistance variable numérique à mémorisation provoque une variation du seuil de commutation. Durant le mode apprentissage, l'unité de traitement agit, en fonction de l'état du signal de détection, sur la valeur de la résistance variable numérique dans le but de déterminer une consigne de fonctionnement de la résistance variable numérique, cette consigne de fonctionnement étant appliquée durant le mode travail. Durant le mode travail, l'unité de traitement est en état de veille.

De plus, le détecteur comprend des moyens de dialogue connectés à l'unité de traitement, destinés notamment à ce qu'un opérateur puisse sélectionner le mode apprentissage ou le mode travail ainsi qu'à informer l'opérateur sur l'état du détecteur.

Le mode apprentissage du détecteur comprend soit un mode apprentissage court dans lequel l'apprentissage du détecteur est réalisé seulement par rapport à son environnement, soit un mode apprentissage long dans lequel l'apprentissage du détecteur est réalisé par rapport à son environnement et par rapport à une cible placée à une distance du détecteur.

La description qui suit d'un mode de réalisation non limitatif, en regard des dessins annexés, illustre les caractéristiques et avantages de l'invention.
- la figure 1 montre l'architecture d'un détecteur de proximité conforme à l'invention,
- la figure 2 représente un organigramme simplifié décrivant le déroulement du mode apprentissage du détecteur.

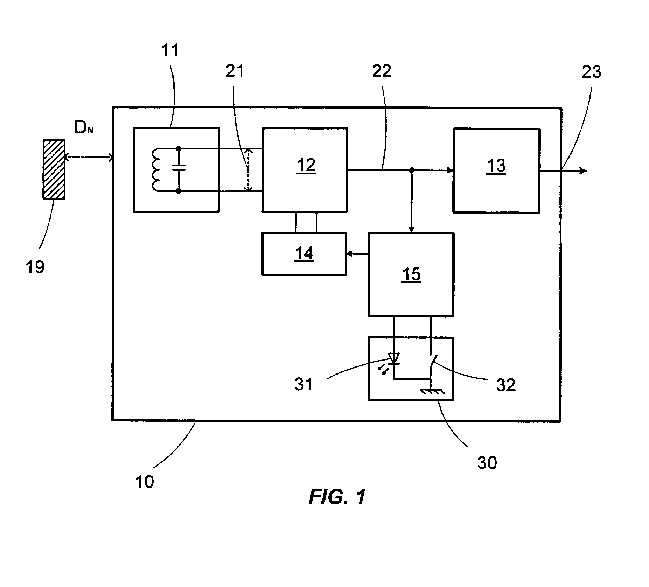

Le détecteur de proximité illustré sur la figure 1 comprend dans un boîtier 10 un organe capteur 11, par exemple de type inductif, qui délivre un signal analogique 21 en fonction de la distance d'une cible 19, par exemple métallique, devant le détecteur 10. Un étage de détection 12 reçoit le signal analogique 21 émis par l'organe capteur 11 et le compare avec un seuil de commutation SC de façon à délivrer un signal de détection 22 binaire, résultat de cette comparaison.

Le détecteur 10 comprend un étage de sortie 13 recevant en entrée le signal de détection 22 et dont le rôle est d'amplifier et de mettre en forme ce signal 22 pour délivrer un signal de sortie binaire 23 du détecteur 10. L'étage de sortie 13 peut comporter par exemple une diode, un thyristor ou un transistor MOS. Le détecteur 10 comprend également une unité de traitement 15, pouvant être avantageusement un microcontrôleur, un microprocesseur, un circuit logique ou autre, qui reçoit en entrée le signal de détection 22 et qui pilote une résistance variable numérique 14 ou un potentiomètre numérique 14 à mémorisation de valeur R. Une résistance variable numérique à mémorisation se définit comme étant une résistance qui varie de façon numérique et non analogique, qui se commande par des signaux logiques et qui est capable de mémoriser en interne sa valeur de réglage.

L'unité de traitement 15 peut notamment donner à la résistance variable numérique 14 des ordres d'affectation de la valeur R à une valeur prédéterminée, des ordres d'incrémentation ou de décrémentation de la valeur R ainsi que des ordres de mémorisation de la valeur R. Une fois la valeur R mémorisée, la résistance variable numérique est autonome et garde cette valeur R même après une coupure d'alimentation. Une résistance variable numérique à mémorisation présente notamment l'avantage de prendre moins de place que plusieurs éléments de résistance ou qu'un réseau de résistances ce qui permet une miniaturisation plus poussée du détecteur. De plus, une fois la valeur R mémorisée, la résistance variable numérique à mémorisation fonctionne de manière indépendante vis-à-vis de l'unité de traitement.

La résistance variable numérique 14 est directement raccordée à l'étage de détection 12 de telle sorte qu'une variation de sa valeur R entraîne une variation du seuil de commutation S_{C}. Ainsi une variation de la valeur R de la résistance numérique 14 peut entraîner un changement d'état du signal de détection 22, alors que la distance entre le détecteur 10 et la cible 19 reste fixe.

Par ailleurs, des moyens de dialogue 30 sont connectés à l'unité de traitement 15 et montés directement sur le détecteur 10. Suivant un mode de réalisation préféré, les moyens de dialogue 30 ne sont constitués que d'une diode électroluminescente 31 pilotée par l'unité de traitement 15 et d'un bouton-poussoir 32, de type micro-switch ou autre organe équivalent, de façon à conserver une solution économique et miniaturisée pour le détecteur 10.

Le détecteur 10 est conçu pour fonctionner selon un mode apprentissage et un mode travail. Le mode apprentissage, dont le but est d'effectuer un réglage de la portée du détecteur, est décrit ci-après. Le mode travail est le mode de fonctionnement normal du détecteur 10 dans lequel l'état du signal de sortie 23, par exemple état ouvert ou état fermé, est fonction de la distance entre une cible 19 et le détecteur 10.

Le passage du mode travail au mode apprentissage se fait par action sur le bouton poussoir 32 des moyens de dialogue 30. L'opérateur a le choix entre deux manières différentes de réaliser l'apprentissage du détecteur 10 : soit un mode apprentissage court A_{C} dans lequel le réglage du détecteur 10 est réalisé seulement par rapport à son environnement, soit un mode apprentissage long A_{L} dans lequel le réglage du détecteur 10 est réalisé par rapport à son environnement puis par rapport à une cible 19 placée à une distance souhaitée D_{N} du détecteur. Le choix du mode d'apprentissage peut être assuré par un appui différencié sur le bouton poussoir 32.

L'intérêt du mode apprentissage court A_{C} est de faire un réglage de la portée maximum admissible du détecteur 10 dans l'environnement considéré, par exemple avec un détecteur monté dans un support métallique ou plastique. L'intérêt du mode apprentissage long A_{L} est de réaliser en plus un réglage de la position souhaitée à laquelle une cible sera effectivement détectée. La portée ainsi obtenue peut donc être très en deçà de la portée maximum admissible dans l'environnement considéré. Cette fonctionnalité permet d'obtenir un détecteur de proximité à apprentissage capable de s'adapter automatiquement à différentes configurations, en fonction du type de cible à détecter et en fonction de l'environnement d'utilisation, de façon à optimiser ainsi la précision du détecteur.

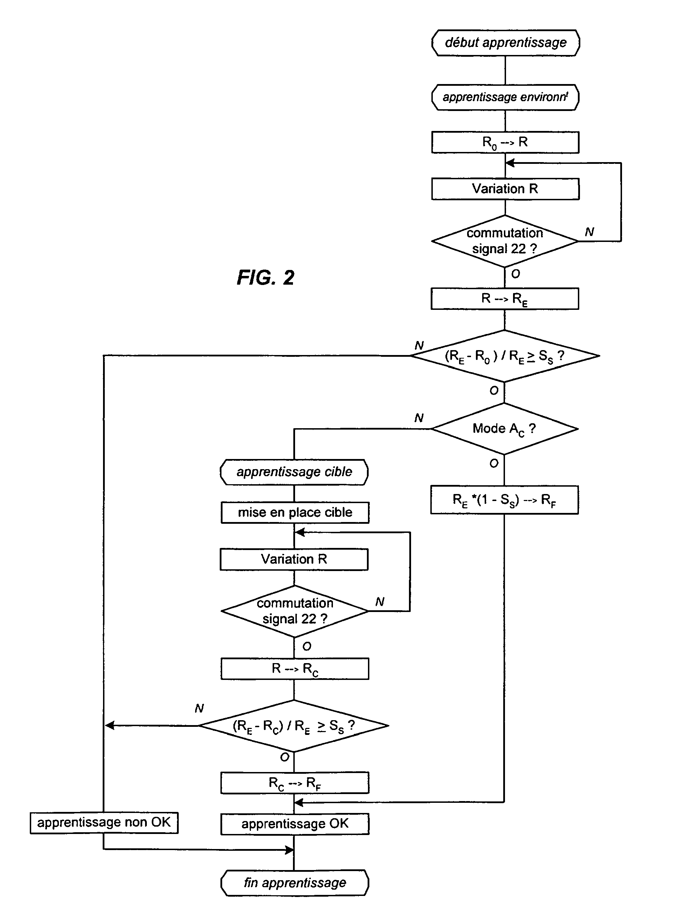

La figure 2 donne un organigramme simplifié du déroulement du mode apprentissage. En mode apprentissage court A_{C} ainsi qu'en mode apprentissage long A_{L}, l'apprentissage du détecteur 10 se fait d'abord par rapport à son environnement (c'est-à-dire au bâti d'une machine, à un arrière-plan, etc...) en dehors de toute présence d'une cible 19. Pour cela l'unité de traitement 15 commence par positionner la valeur R de la résistance variable numérique 14 à une valeur extrême R₀, par exemple une valeur minimale. Ensuite l'unité de traitement 15 fait varier régulièrement cette valeur R, par exemple en l'incrémentant, jusqu'à ce que le signal de détection 22 commute et change d'état. La valeur R correspondante est alors appelée valeur de détection d'environnement R_{E}. L'unité de traitement 15 calcule un écart d'environnement E_{E} = (R_{E} - R₀) / R_{E} et le compare avec un seuil de sensibilité S_{S} interne à l'unité de traitement.

Si l'écart d'environnement E_{E} est inférieur à ce seuil de sensibilité S_{S}, on considère que le détecteur 10 ne dispose pas d'une marge de fonctionnement suffisante pour garantir les paramètres usuels tels que bonne tenue aux normes de compatibilité électromagnétique (CEM), faible dérive en température, etc.... Dans ce cas, la diode électroluminescente 31 des moyens de dialogue 30 signale une indication de défaut indiquant que l'apprentissage n'a pas pu se faire correctement (apprentissage non OK) et l'unité de traitement 15 termine le mode apprentissage.

Si l'écart d'environnement E_{E} est supérieur ou égal au seuil de sensibilité S_{S} et que le mode apprentissage choisi est le mode apprentissage court A_{C}, l'unité de traitement 15 calcule une consigne de fonctionnement R_{F} égale à la valeur de détection d'environnement R_{E} diminuée du seuil de sensibilité S_{S}, R_{F} = R_{E} * (1 - S_{S}), puis applique cette consigne R_{F} à la résistance numérique 14 avant de terminer le mode apprentissage. La résistance numérique 14 mémorisera cette consigne de fonctionnement R_{F} tant qu'elle ne recevra pas un nouvel ordre de modification de la part de l'unité de traitement 15.

Si l'écart d'environnement E_{E} est supérieur ou égal au seuil de sensibilité S_{S} et que le mode apprentissage choisi est le mode apprentissage long A_{L}, l'unité de traitement 15 demande à l'opérateur, au moyen de la diode 31, de positionner la cible 19 à une distance souhaitée D_{N} par l'opérateur pour procéder à l'apprentissage de la cible. Une fois que l'opérateur a averti l'unité de traitement 15 du bon positionnement de la cible 19, l'unité de traitement 15 fait varier régulièrement la valeur R de la résistance numérique 14 jusqu'à ce que le signal de détection 22 commute et change d'état. La valeur R correspondante est alors appelée valeur de détection de cible R_{C}. L'unité de traitement 15 calcule un écart de cible E_{C} = (R_{E} - R_{C} ) / R_{E} et le compare avec le seuil de sensibilité S_{S} interne.

Si l'écart de cible E_{C} est inférieur au seuil de sensibilité S_{S}, on considère que le détecteur 10 ne dispose pas d'une marge de fonctionnement suffisante pour garantir les paramètres usuels tels que bonne tenue aux normes de compatibilité électromagnétique (CEM), faible dérive en température, etc.... Dans ce cas, la diode électroluminescente 31 signale une indication de défaut indiquant que l'apprentissage n'a pas pu se faire correctement (apprentissage non OK) et l'unité de traitement 15 termine le mode apprentissage.

Si l'écart de cible E_{C} est supérieur ou égal au seuil de sensibilité S_{S}, l'unité de traitement 15 calcule une consigne de fonctionnement R_{F} égale à la valeur de détection de cible R_{C}, R_{F} = R_{C}, puis applique cette consigne R_{F} à la résistance numérique 14 avant de terminer le mode apprentissage. La résistance numérique 14 mémorisera cette consigne de fonctionnement R_{F} tant qu'elle ne recevra pas un nouvel ordre de modification de la part de l'unité de traitement 15.

Quand l'apprentissage ne s'est pas déroulé correctement (apprentissage non OK), l'opérateur est donc directement averti par la diode électroluminescente 31 que le détecteur 10 n'est pas en état de fonctionner correctement dans les conditions de réglage souhaitées, et qu'on ne peut pas, en conséquence, lui garantir que le détecteur maintienne l'ensemble de ses performances quelque soit son environnement, la nature de la cible ainsi que la portée demandée.

Quand l'apprentissage s'est déroulé correctement (apprentissage OK), le détecteur bascule automatiquement en mode travail. Comme la résistance numérique 14 est autonome et comme la consigne de fonctionnement R_{F} issue du mode apprentissage est directement mémorisée dans la résistance variable numérique 14, le détecteur 10 est alors capable de fonctionner sans utiliser l'unité de traitement 15. C'est pourquoi, durant tout le mode travail, l'unité de traitement 15 est mise en veille ou dans un état équivalent tel que dans un état d'attente sur une instruction de type "SLEEP". On évite par conséquent au détecteur 10 de consommer trop d'énergie électrique et donc de nécessiter une alimentation plus puissante tout en conservant un faible niveau de courant de fuite garanti pour le signal de sortie 23. L'unité de traitement 15 passe en état de veille à la fin du mode apprentissage, et sort de son état de veille quand un opérateur actionne de manière appropriée le bouton poussoir 32 pour passer en mode apprentissage. Ainsi, un tel détecteur de proximité est capable de dissiper un courant de fuite maximal inférieur ou égal à 1,5 mA en mode travail sous une alimentation alternative ou continue. Ce faible courant de fuite est un avantage substantiel permettant au détecteur d'utiliser une technologie de sortie deux fils.

De façon équivalente, pour maintenir un courant de fuite maximal inférieur ou égal à 1,5 mA en mode travail, on pourrait minimiser la consommation électrique de l'unité de traitement 15 grâce à un ou plusieurs des paramètres suivants : abaisser la fréquence d'horloge de l'unité de traitement 15 (par exemple à une fréquence inférieure à 50 kHz), abaisser la tension d'alimentation de l'unité de traitement 15 (par exemple à une tension inférieure à 3 V), mettre l'unité de traitement 15 en état de veille en mode travail.

Il est bien entendu que l'on peut, sans sortir du cadre de l'invention, imaginer d'autres variantes et perfectionnements de détail et de même envisager l'emploi de moyens équivalents.

## Revendications

1. Détecteur de proximité comprenant :
- un organe capteur (11) apte à délivrer un signal analogique (21) en fonction de la distance d'une cible (19),
- un étage de détection (12) capable de délivrer un signal de détection (22) résultat de la comparaison entre le signal analogique (21) et un seuil de commutation (S_{C}),
- un étage de sortie (13) chargé d'amplifier et de mettre en forme le signal de détection (22) pour délivrer un signal logique de sortie (23), et
- une unité de traitement (15) recevant en entrée le signal de détection (22),
- le détecteur (10) étant conçu pour fonctionner selon un mode apprentissage correspondant à un réglage de portée du détecteur et selon un mode travail correspondant au mode de fonctionnement normal du détecteur,
- le détecteur (10) comprenant une résistance variable numérique (14) à mémorisation, pilotée par l'unité de traitement (15) en mode apprentissage et reliée à l'étage de détection (12) de telle façon qu'une variation de la valeur (R) de la résistance variable numérique (14) provoque une variation du seuil de commutation (S_{C}),
**caractérisé par le fait que** le mode apprentissage comprend un mode apprentissage court (A_{C}) dans lequel l'apprentissage du détecteur (10) est réalisé seulement par rapport à son environnement, et un mode apprentissage long (A_{L}) dans lequel l'apprentissage du détecteur (10) est réalisé par rapport à son environnement puis par rapport à une cible (19) placée à une distance (D_{N}) du détecteur.

2. Détecteur de proximité selon la revendication 1, **caractérisé par le fait que**, durant le mode apprentissage, l'unité de traitement (15) fait varier la valeur (R) de la résistance variable numérique (14) jusqu'à commutation du signal de détection (22), dans le but de déterminer une consigne de fonctionnement (R_{F}) mémorisée dans la résistance variable numérique (14) et appliquée durant le mode travail.

3. Détecteur de proximité selon la revendication 1, **caractérisé par le fait que** l'unité de traitement (15) est en état de veille quand le détecteur (10) est en mode travail.

4. Détecteur de proximité selon la revendication 1, **caractérisé par le fait que** le détecteur (10) comprend des moyens de dialogue (30) connectés à l'unité de traitement (15) destinés notamment à ce qu'un opérateur puisse sélectionner le mode apprentissage ou le mode travail et à informer l'opérateur sur l'état du détecteur (10).

5. Détecteur de proximité selon la revendication 4, **caractérisé par le fait que** les moyens de dialogue (30) comprennent un bouton poussoir (31) et une diode électroluminescente (32) montés directement sur le détecteur (10).

6. Détecteur de proximité selon la revendication 4, **caractérisé par le fait que** le choix entre le mode apprentissage court (A_{C}) et le mode apprentissage long (A_{L}) est fait grâce aux moyens de dialogue (30).

7. Détecteur de proximité selon la revendication 4, **caractérisé par le fait que**, durant l'apprentissage du détecteur par rapport à son environnement, l'unité de traitement (15) positionne la résistance variable numérique (14) à une valeur extrême (R₀) puis fait varier la résistance variable numérique (14) jusqu'à une valeur de détection d'environnement (R_{E}) correspondant à une commutation du signal de détection (22).

8. Détecteur de proximité selon la revendication 7, **caractérisé par le fait que** l'unité de traitement (15) calcule un écart d'environnement (E_{E}) fonction de la valeur de détection d'environnement (R_{E}) et de la valeur extrême (R₀), puis, si l'écart d'environnement (E_{E}) est inférieur à un seuil de sensibilité (S_{S}) contenu dans l'unité de traitement, signale un défaut et la fin du mode apprentissage grâce aux moyens de dialogue (30).

9. Détecteur de proximité selon la revendication 8, **caractérisé par le fait que**, en mode apprentissage court (A_{C}), si l'écart d'environnement (E_{E}) est supérieur ou égal au seuil de sensibilité (S_{S}), l'unité de traitement (15) positionne la résistance variable numérique (14) à une consigne de fonctionnement (R_{F}), qui est égale à la valeur de détection d'environnement (R_{E}) diminuée du seuil de sensibilité (S_{S}), signale la fin du mode apprentissage grâce aux moyens de dialogue (30) et passe automatiquement en mode travail.

10. Détecteur de proximité selon la revendication 8, **caractérisé par le fait que**, en mode apprentissage long (A_{L}) et après qu'une cible (19) ait été placée à une distance (D_{N}) du détecteur, l'unité de traitement (15) fait varier la résistance variable numérique (14) jusqu'à une valeur de détection de cible (R_{C}) correspondant à une commutation du signal de détection (22).

11. Détecteur de proximité selon la revendication 10, **caractérisé par le fait que**, en mode apprentissage long (A_{L}), l'unité de traitement (15) calcule un écart de cible (E_{C}) fonction de la valeur de détection de cible (R_{C}) et de la valeur de détection d'environnement (R_{E}), puis, si l'écart de cible (E_{C}) est inférieur au seuil de sensibilité (S_{S}) contenu dans l'unité de traitement, signale un défaut grâce aux moyens de dialogue (30) et, si l'écart de cible (E_{C}) est supérieur ou égal au seuil de sensibilité (S_{S}), positionne la résistance variable numérique (14) à une consigne de fonctionnement (R_{F}) égale à la valeur de détection de cible (R_{C}), signale la fin du mode apprentissage grâce aux moyens de dialogue (30) et passe automatiquement en mode travail.

## Claims

1. A proximity detector comprising:
- a sensor unit (11) able to deliver an analog signal (21) according to the distance of a target (19),
- a detection stage (12) capable of delivering a detection signal (22), resulting from the comparison between the analog signal (21) and a switching threshold (S_{C}),
- an output stage (13) for amplifying and shaping the detection signal (22), in order to deliver an output logic signal (23), and
- a processing unit (15) receiving as an input the detection signal (22),
- the detector (10) being designed for operating according to a learning mode corresponding to an adjustment of the range of the detector and according to a working mode corresponding to the normal operating mode of the detector,
- the detector (10) comprising a variable digital storage resistance (14), driven by the processing unit (15) in the learning mode and connected to the detection stage (12) in such a way that a variation of the value (R) of the variable digital resistance (14) causes a variation of the switching threshold (S_{C}),
**characterized by** the fact that the learning mode comprises a short learning mode (A_{C}) wherein the teaching of detector (10) is only performed relatively to its environment, and a long learning mode (A_{L}) wherein the teaching of detector (10) is performed relatively to its environment and relatively to a target (19) placed at a distance (D_{N}) from the detector.

2. The proximity detector according to claim 1, **characterized by** the fact that, during the learning mode, the processing unit (15) varies the value (R) of the variable digital resistance (14) until the detection signal (22) switches, for the purpose of determining a set operating value (R_{F}) stored in the variable digital resistance (14) and applied during the working mode.

3. The proximity detector according to claim 1, **characterized by** the fact that the processing unit (15) is in a standby state when the detector (10) is in the working mode.

4. The proximity detector according to claim 1, **characterized by** the fact that the detector (10) comprises conversing means (30) connected to the processing unit (15) notably for enabling an operator to select the learning mode or the working mode and for informing the operator on the state of the detector (10).

5. The proximity detector according to claim 4, **characterized by** the fact that the conversing means (30) comprise a push button (31) and a light emitting diode (32) directly mounted on the detector (10).

6. The proximity detector according to claim 4, **characterized by** the fact that the selection between the short learning mode (A_{C}) and the long learning mode (A_{L}) is performed through the conversing means (30).

7. The proximity detector according to claim 4, **characterized by** the fact that during the teaching of the detector relatively to its environment, the processing unit (15) sets the variable digital resistance (14) to an extreme value (R₀), then varies the variable digital resistance (14) up to an environment detection value (R_{E}) corresponding to a switching of the detection signal (22).

8. The proximity detector according to claim 7, **characterized by** the fact that the processing unit (15) calculates an environmental difference (E_{E}) depending on the environment detection value (R_{E}) and on the extreme value (R₀), then, if the environmental difference (E_{E}) is less than a sensitivity threshold (S_{S}) contained in the processing unit, it signals a fault and the end of the learning mode through the conversing means (30).

9. The proximity detector according to claim 8, **characterized by** the fact that in the short learning mode (A_{C}), if the environmental difference (E_{E}) is greater than or equal to the sensitivity threshold (S_{S}), the processing unit (15) sets the variable digital resistance (14) to a set operating value (R_{F}), which is equal to the environment detection value (R_{E}) reduced by the sensitivity threshold (S_{S}), it signals the end of the learning mode through the conversing means (30) and switches back to the working mode automatically.

10. The proximity detector according to claim 8, **characterized by** the fact that in the long learning mode (A_{L}) and after having placed a target (19) at a distance (D_{N}) from the detector, the processing unit (15) varies the variable digital resistance (14) up to a target detection value (R_{C}) corresponding to a switching of the detection signal (22).

11. The proximity detector according to claim 10, **characterized by** the fact that in the long learning mode (A_{L}), the processing unit (15) calculates a target difference (E_{C}) depending on the target detection value (R_{C}) and on the environment detection value (R_{E}), then, if the target difference (E_{C}) is less than the sensitivity threshold (S_{S}) contained in the processing unit, it signals a fault through the conversing means (30) and, if the target difference (E_{C}) is greater than or equal to the sensitivity threshold (S_{S}), it sets the variable digital resistance (14) to a set operating value (R_{F}) equal to the target detection value (R_{C}), it signals the end of the learning mode through the conversing means (30) and switches back to the working mode automatically.

## Patentansprüche

1. Näherungsschalter, der enthält:
- ein Sensororgan (11), das ein Analogsignal (21) abhängig von der Entfernung eines Ziels (19) liefern kann,
- eine Erfassungsstufe (12), die ein Erfassungssignal (22) liefern kann, das das Ergebnis des Vergleichs zwischen dem Analogsignal (21) und einer Schaltschwelle (S_{C}) ist,
- eine Ausgangsstufe (13), die die Aufgabe hat, das Erfassungssignal (22) zu verstärken und zu formen, um ein logisches Ausgangssignal (23) zu liefern, und
- eine Verarbeitungseinheit (15), die am Eingang das Erfassungssignal (22) empfängt,
- wobei der Detektor (10) konzipiert ist, um gemäß einem Lernmodus, der einer Regelung der Reichweite des Detektors entspricht, und gemäß einem Arbeitsmodus zu arbeiten, der dem normalen Betriebsmodus des Detektors entspricht,
- wobei der Detektor (10) einen veränderlichen digitalen Widerstand (14) mit Speicherung enthält, der von der Verarbeitungseinheit (15) im Lernmodus gesteuert wird und mit der Erfassungsstufe (12) so verbunden ist, dass eine Veränderung des Werts (R) des veränderlichen digitalen Widerstands (14) eine Veränderung der Schaltschwelle (S_{C}) bewirkt, **dadurch gekennzeichnet, dass** der Lernmodus einen kurzen Lernmodus (A_{C}), in dem das Lernen des Detektors (10) nur bezüglich seiner Umgebung durchgeführt wird, und einen langen Lernmodus (A_{L}) enthält, in dem das Lernen des Detektors (10) bezüglich seiner Umgebung und dann bezüglich eines Ziels (19) durchgeführt wird, das in einer Entfernung (D_{N}) vom Detektor angeordnet ist.

2. Näherungsschalter nach Anspruch 1, **dadurch gekennzeichnet, dass** während des Lernmodus die Verarbeitungseinheit (15) den Wert (R) des veränderlichen digitalen Widerstands (14) bis zum Umschalten des Erfassungssignals (22) verändert, um einen Betriebssollwert (R_{F}) zu bestimmen, der im veränderlichen digitalen Widerstand (14) gespeichert ist und während des Arbeitsmodus angewendet wird.

3. Näherungsschalter nach Anspruch 1, **dadurch gekennzeichnet, dass** die Verarbeitungseinheit (15) im Standby-Zustand ist, wenn der Detektor (10) im Arbeitsmodus ist.

4. Näherungsschalter nach Anspruch 1, **dadurch gekennzeichnet, dass** der Detektor (10) mit der Verarbeitungseinheit (15) verbundene Dialogeinrichtungen (30) enthält, die insbesondere dazu bestimmt sind, dass ein Bediener den Lernmodus oder den Arbeitsmodus auswählen kann, und den Bediener über den Zustand des Detektors (10) zu informieren.

5. Näherungsschalter nach Anspruch 4, **dadurch gekennzeichnet, dass** die Dialogeinrichtungen (30) einen Drücker (31) und eine Elektrolumineszenzdiode (32) enthalten, die direkt auf den Detektor (10) montiert sind.

6. Näherungsschalter nach Anspruch 4, **dadurch gekennzeichnet, dass** die Wahl zwischen dem kurzen Lernmodus (A_{C}) und dem langen Lernmodus (A_{L}) mit Hilfe der Dialogeinrichtungen (30) erfolgt.

7. Näherungsschalter nach Anspruch 4, **dadurch gekennzeichnet, dass** während des Lernens des Detektors bezüglich seiner Umgebung die Verarbeitungseinheit (15) den veränderlichen digitalen Widerstand (14) auf einem Extremwert (R₀) positioniert und dann den veränderlichen digitalen Widerstand (14) bis zu einem Umgebungserfassungswert (R_{E}) variieren lässt, der einer Umschaltung des Erfassungssignals (22) entspricht.

8. Näherungsschalter nach Anspruch 7, **dadurch gekennzeichnet, dass** die Verarbeitungseinheit (15) eine Umgebungsabweichung (E_{E}) abhängig vom Umgebungserfassungswert (R_{E}) und vom Extremwert (R₀) berechnet, und dann, wenn die Umgebungsabweichung (E_{E}) unter einer in der Verarbeitungseinheit enthaltenen Empfindlichkeitsschwelle (S_{S}) liegt, mit Hilfe der Dialogeinrichtungen (30) einen Fehler und das Ende des Lernmodus anzeigt.

9. Näherungsschalter nach Anspruch 8, **dadurch gekennzeichnet, dass** im kurzen Lernmodus (A_{C}), wenn die Umgebungsabweichung (E_{E}) höher als die oder gleich der Empfindlichkeitsschwelle (S_{S}) ist, die Verarbeitungseinheit (15) den veränderlichen digitalen Widerstand (14) auf einem Betriebssollwert (R_{F}) positioniert, der gleich dem Umgebungserfassungswert (R_{E}) verringert um die Empfindlichkeitsschwelle (S_{S}) ist, das Ende des Lernmodus mit Hilfe der Dialogeinrichtungen (30) anzeigt und automatisch in den Arbeitsmodus übergeht.

10. Näherungsschalter nach Anspruch 8, **dadurch gekennzeichnet, dass** im langen Lernmodus (A_{L}), und nachdem ein Ziel (19) in einer Entfernung (D_{N}) zum Detektor angeordnet wurde, die Verarbeitungseinheit (15) den veränderlichen digitalen Widerstand (14) bis zu einem Zielerfassungswert (R_{C}) variieren lässt, der einer Umschaltung des Erfassungssignals (22) entspricht.

11. Näherungsschalter nach Anspruch 10, **dadurch gekennzeichnet, dass** im langen Lernmodus (A_{L}) die Verarbeitungseinheit (15) eine Zielabweichung (E_{C}) abhängig vom Zielerfassungswert (R_{C}) und vom Umgebungserfassungswert (R_{E}) berechnet, dann, wenn die Zielabweichung (E_{C}) unter der in der Verarbeitungseinheit enthaltenen Empfindlichkeitsschwelle (S_{S}) liegt, mit Hilfe der Dialogeinrichtungen (30) einen Fehler anzeigt, und wenn die Zielabweichung (E_{C}) höher als die oder gleich der Empfindlichkeitsschwelle (S_{S}) ist, den veränderlichen digitalen Widerstand (14) auf einem Betriebssollwert (R_{F}) gleich dem Zielerfassungswert (R_{C}) positioniert, das Ende des Lernmodus mit Hilfe der Dialogeinrichtungen (30) anzeigt und automatisch in den Arbeitsmodus übergeht.
